# EUROPEAN PATENT APPLICATION

(11) **EP 1 626 239 A1**
(43) Date of publication of application: **15.02.2006**
(21) Application number: 05107403.7
(22) Date of filing: 11.08.2005
(51) Int. Cl.: F28D 15/00, H01L 23/473, H05K 7/20

(54) **Heat exchanger and method of production thereof**

(30) Priority: 13.08.2004 IT MI20041652
(71) Applicant: Bosari Thermal Management S.r.L., 20090 Opera (IT)
(72) Inventor: Bosari, Bruno, 20159 Milano (IT)
(74) Representative: Borsano, Corrado

(57) **Abstract**

A heat exchanger for conditioning of an electronic device is provided, comprising a main body (10,100) with a heat exchange first surface (11,12,102) to convey a heat-exchange fluid and a second heat exchange surface (20, 104) to interface with such electronic device, and is characterized in that it comprises ducts (103, 110, 111) that convey such fluid which are obtained integrally on such at least first surface (11,12,102) of such main body (10,100). The invention also provides a method for producing said exchanger.

## Description

### Scope of the invention

The invention refers to a heat exchanger that can be used in particular to cool electronic power components such as, for example, inverters, converters, choppers, derating or switching components; the invention also refers to the method of producing such heat exchanger.

### Prior art

To cool electronic power components such as, for example, the inverters that convert a DC current into an AC current in the electrical traction railway sector, the current art is to use exchangers or heat sinks to be applied to the body of the electronic component.

There is a first type of heat sink that consists of an external enclosure designed to be fastened to a flat side of the electronic component to be cooled. The enclosure is airtight and, inside, features a plurality of stacked metal disks. Each disk has a plurality of straight slots, usually created through shearing. The disks are stacked in the enclosure at an offset angle in relation to each other so that, in a plan view of the stack of disks, the plurality of slots intersect each other and form a set of ducts.

In this way, the cooling fluid that enters and drains from inlet and outlet fittings can flow through the pack of disks.

On the other hand, there is a second type of heat sink in which the heat dispersion body consists of finned, more or less disk-shaped heat exchange bodies each of which has a plurality of cooling fins. The heat sink body consists of an extruded metal section that is subsequently cut along a circular edge. The two finned circular bodies thus obtained are then inserted in an enclosure with the fins of one resting and offset in relation to the other and at a staggered angle so that they are not parallel with each other in order to form a set of passageways through which a cooling fluid may pass through the entire pack.

These types of heat exchangers are characterized by various disadvantages. A first disadvantage lies in the fact that the related production processes does not readily adapt to the changes in performance required by the various applications for which they are intended. In fact, permissible overall dimensions, required heat exchange capacity, delivery and pressure of the cooling fluid vary according to use. In these cases, it is necessary to modify the dimensions of the sheared metal disks or finned bodies but the cost of modifying the shearing dies of the disks or the extrusion molds of the finned bodies make production of such exchangers in small lots, a typical situation in the railway sector, not very or not at all cost-effective.

The purpose of the invention is to overcome the aforementioned disadvantages providing a heat exchanger suitable for more cost-effective production in small lots compared with the known type exchangers described above

### Summary of the invention

This purpose is achieved, according to a first aspect of the invention, with a heat exchanger able to afford heat exchange between a heat-exchange fluid and a body to be conditioned, basically as described in claim 1.

According to a second aspect of the invention, such purpose is achieved providing a method for the production of the heat exchangers described above, characterized by the fact of obtaining, through chip removal, at least part of a heat exchange duct.

The invention offers a number of advantages. A first advantage lies in the fact of using a tool to machine one or more grooves in the heat exchange body. Following particularly optimal and advantageous tool paths, it is possible to produce, at convenient production costs, via chip removal machining or other type of CNC machining, small and relatively large production lots with highly versatile adaptation of the layout of the heat exchange ducts and complete thermal/hydraulic scaling of the heat exchanger according to the requirements of the specific application.

Further advantages that can be achieved with this invention will be more evident to the sector technician in the following detailed description of an example of a particular non-restrictive embodiment referring to the following figures:

### List of figures

Figure 1 is a schematic representation of a plan view of a first heat exchanger of known type for cooling of a railway inverters, consisting of stacks of sheared metal disks;
Figure 2 is a schematic representation of a plan view of a sheared metal disk of the exchanger of Figure 1;
Figure 3 is a schematic representation of a plan view of a finned heat exchange body for a second heat exchanger for the cooling of railway inverters of known type;
Figure 4 is a side view of the finned body of Figure 3;
Figure 5 is a schematic representation of a plan view of the heat exchange body of a heat exchanger according to a first embodiment of the invention;
Figure 6 is a schematic representation of a side view of the heat exchange body of Figure 5;
Figure 7 is a schematic representation of a front view of the heat exchange body of Figure 5;
Figure 8 is a schematic representation of a plan view of the heat exchange body of a heat exchanger according to a second embodiment of the invention;
Figures 9 and 10 are a schematic representation respectively of a plan view and side view of the closing body of the heat exchanger according to the embodiment of Figure 8;
Figure 11 is a schematic representation of a front view of the heat exchanger according to the embodiment of Figure 8 with the outer shell closed;
Figure 12 is a schematic representation of a cross-section side view in the plane of section A-A of the heat exchange body of Figure 8;
Figures 13 and 14 are schematic representations of the cross-sections of heat exchanger grooves according to two embodiments of the invention.

### Detailed description of the invention

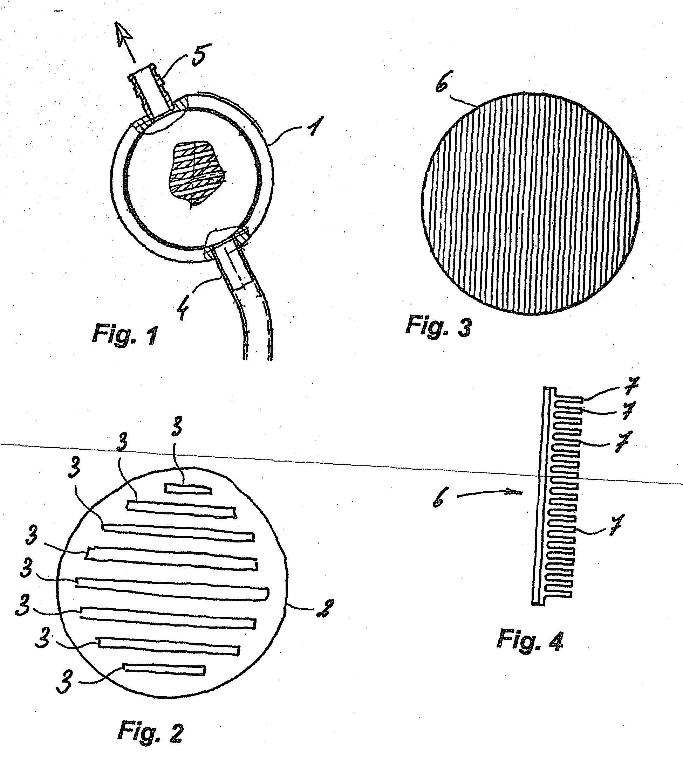

Referring to Figures 1 and 2, these illustrate a first type of heat exchanger of the known state of the art. More precisely, the exchanger consists of an external airtight enclosure 1 in which a plurality of sheared metal disks 2 are stacked. A set of straight slots 3 has been cut into each disk 2. The various disks 2 are stacked in the enclosure 1 at a staggered angle so that the slots 3 of the various disks 2 intersect (in a plan view seen from above).

In this way, a cooling fluid that enters and drains respectively through inlet 4 and outlet 5 fittings can flow through the stack of disks.

Also, the enclosure 1 is characterized by a flat side designed to be fastened to an electronic component to be cooled so that the heat of the electronic component is transmitted through thermal conduction to the stack of disks 3 and this is cooled by the cooling fluid.

Referring to the figures 3 and 4, these illustrate a second type of state-of-the-art heat sink. According to this type of heat sink, the heat dispersion body consists of two finned, more or less disk-shaped bodies 6 each with a plurality of cooling fins 7. Each finned body 6 is obtained extruding a metal section that is then cut along a circular edge. For assembly, the two finned bodies 6 are inserted in a enclosure 1 with the fins 7 resting and offset in relation to the other and at a staggered angle so that they are not parallel with each other so as to form a set of passageways through which a cooling fluid may pass through the entire stack.

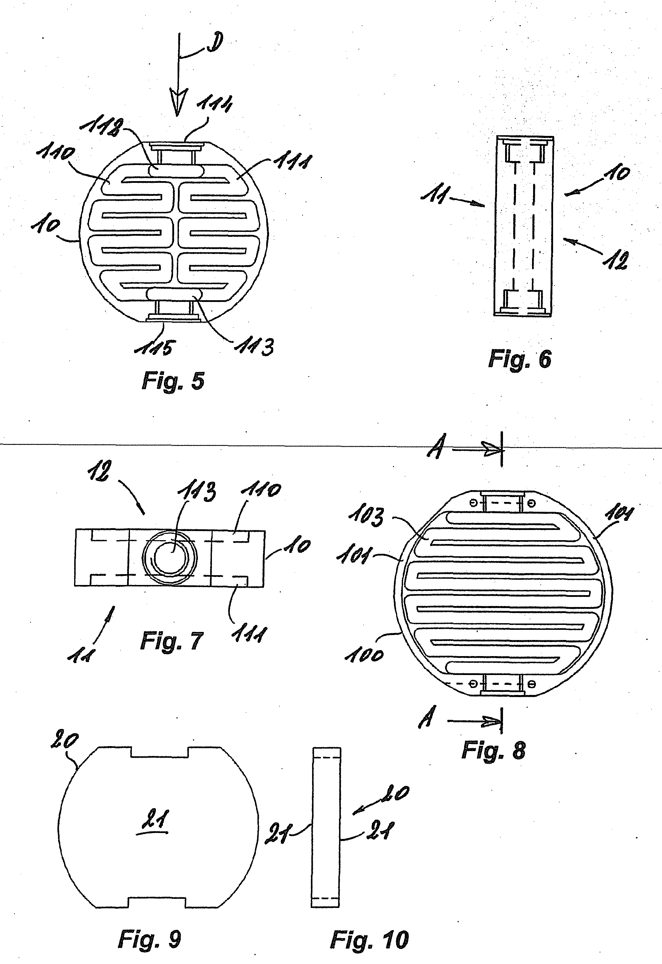

Referring to figures 5 to 7, these illustrate a first example of a preferred embodiment of a heat exchanger according to the invention. It should be noted that the heat exchanger illustrated is particularly suitable for dispersion of the heat produced by inverters for the transformation of DC current into AC current in railway applications but may also be used in other similar applications. According to the invention, the heat sink is characterized by a more or less disk-shaped heat exchange body 10 which has two faces 11 and 12 and is made of a material of suitable thermal conductivity such as, for example, aluminum.

According to this example of a preferred embodiment of the invention, in each of the two faces 11 and 12 of the heat exchange body 10 there are two grooves 110 and 111 which follow a coil type path, with a set of U-bends. Such grooves 110 and 111 are advantageously obtained through chip removal machining following particularly optimal and advantageous tool paths.

In fact, the coil type path makes it possible to achieve a particularly optimal compromise between cost-effective production of small, medium or even relatively large lots and heat exchange efficiency, losses of head and erosion along the ducts due to the flow of heat-exchange fluid and also compliance with design restraints such as, for example, overall dimensions and connections to the rest of the hydraulic circuit of the heat-exchange fluid.

In many cases, the embodiments with coil type ducts make it possible to obtain, with the same heat exchange efficiency, lower losses of head than heat exchangers of known type with stacks of sheared metal disks or with finned disks or with ducts that form a coil.

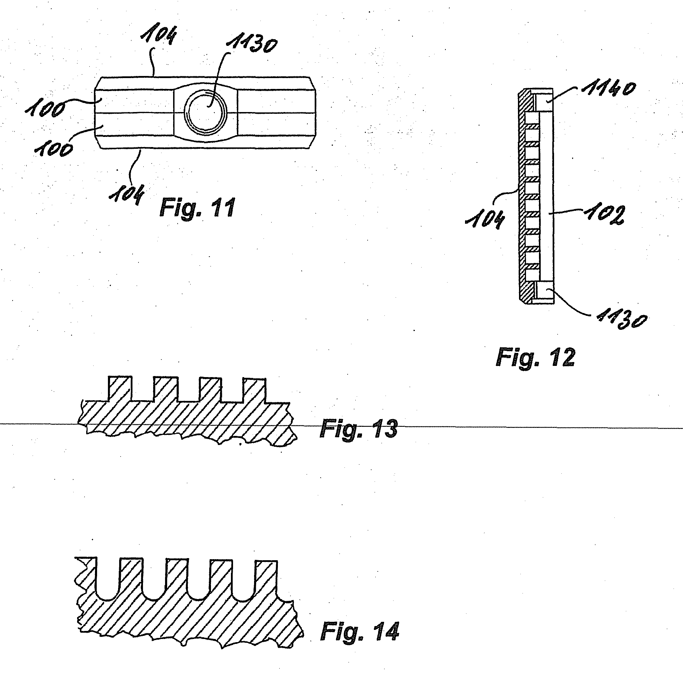

With particular reference to figures 13 and 14, the grooves 110 and 111 when viewed in cross-section may alternatively have an open crosswise section of passageway that may be of rectangular shape (figure 13) or alternatively with the bottom rounded (Figure 14).

Furthermore, as illustrated in figure 5, the grooves 110 and 111 flow towards inlet 112 and outlet 113 zones on the heat exchange body 10, in these zones, the heat-exchange fluid can flow from the outside towards the ducts formed by the grooves 110 and 111 in order to drain towards the outside of the heat exchange body 10 from the opposite side. In Figure 5, references 114 and 115 indicate the inlet and outlet of the heat-exchange fluid from/to the zones 112 and 113 of the respective coil type ducts 110 and 111.

On the other hand, according to the invention, the grooves 110 and 111 form ducts able to convey a suitable heat-exchange fluid when they are closed. The aforementioned grooves 110 and 111 are closed in various ways. According to a first embodiment and with particular reference to figures 7 and 9, a simple closing plate 20 may be applied to each face 11 and 12 of the heat exchange body 10 through gluing, welding, solder-brazing or soft soldering.

Alternatively, it is possible to couple together two heat exchange bodies 10 on which coils are formed or more generally symmetrical grooves 110 and 11.

In a further alternative variant, the exchanger can be constructed closing both faces 11 and 12 with two flat plates 20 for closing of the heat exchange ducts 110 and 111 on both faces 11, 12 of the body 10. According to this arrangement, each of the two free outer faces of the two closing plates 20 can be fastened and put into contact with an electronic power component, for example an inverter to be cooled, so that the heat produced by these electronic components is transmitted by conduction to the closing plates and from these to the cooling fluid that flows in the coils 110 and 111.

In this case, to facilitate heat exchange through conduction between the closing plates and the body 10, the closing plates will be fastened to the body 10 through brazing or other types of welding.

According to the invention, it is possible to create assemblies or stacks with multiple arrangements of inverters - closing plate - body 10 - closing plate - inverter sandwiches that may be of any useful size and repeated as required so as to from stacks in which to cool the required number of inverters; such stacks may be held together with suitable mechanical fasteners, for example, sets of tie-bolts or clamps of known type.

Also, it should be noted that the configuration of the coil type ducts 110 and 111 makes it possible to optimize the milling tool path which forms such ducts 110, 111, and to increase their length, dimensions and weight of the heat exchange body 10 being equal, thereby enhancing the thermal efficiency of the exchanger.

Advantageously, production using CNC milling of a solid piece of metal permits maximum optimization at acceptable costs (also in the case of very small production lots) of the shape of the coil and therefore the performance of the exchanger. This therefore eliminates initial investments in shearing dies or extrusion molds necessary to reproduce known art exchangers.

Referring to the figures from 8 to 12, these illustrate a second example of a preferred embodiment of a heat exchanger according to the invention.

According to such example of embodiment, the heat exchanger comprises two half-shells 100 in between which a closing plate 20 is inserted and closed.

Each shell 100, also indicated in this description as heat exchange body 100, comprises an outer edge 101 that encloses an indentation 102 on the basically flat bottom of which there is a groove that forms a cooling coil 103. On the opposite side to that of the coil 103, the heat exchange body 100 is characterized by a surface 104 that can be put in to contact with an inverter or other electronic component to be cooled and in such a way as to exchange heat therewith mainly through conduction.

As illustrated in figure 11, the shape and thickness of the closing plate 20 are such that it can be inserted in both indentations 102 of the two opposite half-shells 100 and closed in between these so as to close the open side of the crosswise sections of the coil type grooves 103 of both half-shells 100, thereby forming two coil type ducts through which the cooling fluid can flow.

More precisely, the fluid enters through opening 1130 and is split by the closing plate 20 into two parallel streams, one for each coil. The opposed two half-shells 100 are fastened together through, for example, gluing or brazing so as to form a single body or airtight shell.

Also for this embodiment of the exchanger, it is possible to form sandwich type assemblies of the electronic device and exchanger that can be repeated as required in order to stack and cool the necessary number of electronic devices.

During experimental tests carried out by the applicant, it was noted in various cases that the number of heat exchange ducts or coils formed on each heat exchange body that affords the best compromise between losses of head of the fluid through the ducts and heat exchange efficiency and reduction of corrosion of the ducts due to flow of the heat-exchange fluid, consists of two coils in parallel on each of the two faces of the cooling body 10.

Also, another often particularly advantageous embodiment is that of a cooling body with two faces and a coil on each face, as shown in figure 8.

Furthermore, it was found that the embodiment of the Figures from 5 to 7, i.e. with two faces and two coils per face, compared with the embodiment with two faces and a single coil per face (Figure 8), makes it possible to achieve more or less equal heat exchange performance levels with lower losses of head. This is particularly advantageous in applications (for example railway applications) in which high capacity, low head fluid circulation pumps are used.

An exchanger according to the invention may, however, be constructed to operate with high losses of head, and therefore with even high thermal efficiency, modifying the dimensions of the heat exchange ducts. For example, heat exchangers according to the invention can operate with variable losses of head from around 10⁴ Pascal and 4 X 10⁵ Pascal, and variable delivery from 1 to 8 liters/minute.

A further advantage of the embodiment with several cooling ducts in parallel is that of reducing, compared with known exchangers, the speed at which the heat-exchange fluid flows in the exchanger, avoiding or in any case considerably reducing the erosion that, during the service life of the exchanger - often at least thirty years - could gradually impair functioning.

Many modifications and changes may be made to embodiments described previously without however overstepping the scope of the invention.

For example, even three or more coils or heat exchange ducts can be formed in each heat exchange body; the path of each heat exchange duct may also be not of the coil type but for example form other types of U-bends or even spiral type paths; in the preceding examples of embodiment, the heat exchange body was of basically flattened shape and the cooling ducts extended, at least in their intermediate section, more or less on planes parallel to that of the heat exchange body itself.

The cross-sections of the ducts 103, 110, 111 may be of various shapes, for example rectangular or square (Figure 13) or with the bottom rounded (Figure 14): the rectangular or square cross-sections afford greater thermal efficiency but entail greater milling difficulties while the cross-sections with rounded bottom such as those shown in Figure 14 are easier to mill but offer much lower thermal efficiency. Other shapes are also possible.

Alternatively the heat exchange body and the heat exchange ducts may be formed with different types of machining other than chip removal, for example, hot molding or pressure casting.

## Claims

1. Heat exchanger for the conditioning of an electronic device comprising at least a main body (10,100) which has at least a first heat exchanging surface (11,12,102) for conveying a heat exchange fluid, and at least a second heat exchanging surface (20, 104) for interfacing said electronic device,
the exchanger is **characterized in that** it comprises means (103, 110, 111) for conveying said fluid which are integrally formed on said first surface (11,12,102) of said main body (10,100).

2. Heat exchanger for the conditioning of an electronic device according to the preceding claim, wherein said conveying means includes at least a groove (103, 110, 111) formed on said first heat exchanging surface (11,12,102).

3. Heat exchanger for the conditioning of an electronic device according to the claim 2, wherein said at least a groove (103, 110, 111) is integrally formed on the most of the surface of said first surface (11,12,102) and is shaped with a series of parallel grooves joined by curved joining sections.

4. Heat exchanger for the conditioning of an electronic device according to claim 1 or 2 or 3, wherein said at least a groove (103,110,111) has a square cross-section.

5. Heat exchanger for the conditioning of an electronic device according to claim 1 or 2 or 3, wherein said at least a groove (103,110,111) has a U-shaped cross-section.

6. Heat exchanger for the conditioning of an electronic device according to any of the preceding claims, wherein said at least a groove (103,110,111) terminates at its two ends with respective inlet (112) and outlet (113) regions integrally formed on said heat exchange body (10, 100).

7. Heat exchanger for the conditioning of an electronic device according to any of the preceding claims, further comprising at least a flat closing plate (20) of said at least a first surface (11,12,102), said closing plate being complementary to the shape of said at least a first surface (11,12,102) and for being airtight mounted thereon.

8. Heat exchanger for the conditioning of an electronic device according to any of the preceding claims, wherein said at least a heat exchange body (10) comprises at least two grooves (110,111) obtained on said at least a first heat exchanging surface (11,12,102) in communication with each other at respective inlet (112) and outlet (113) regions, said grooves (110, 111) and said inlet and outlet regions (112,113) being formed integrally on said heat exchange body (10).

9. Heat exchanger for the conditioning of an electronic device according to any of the preceding claims, wherein said main body (10) has two first heat exchanging surfaces (11,12) and each having at least one groove (103,110,111).

10. Heat exchanger for the conditioning of an electronic device according to any of the preceding claims from 1 to 8, wherein said main body (100) has the shape of a half shell, and said first heat exchanging surface (102) comprises at least a groove (103) being formed on the inside said main body (100) and said second heat exchanging surface (104) being formed on the outside of said main body (100).

11. Heat exchanger for the conditioning of an electronic device according to the preceding claim, further comprising two main bodies (10) having first heat exchange surfaces (102), and a closing plate (20), the arrangement being such that the exchanger is formed when said closing plate (20) is air-tight inserted as a "sandwich" between said two main bodies and between said first heat exchange surfaces (102).

12. Method of production of an heat exchanger for the conditioning of an electronic device according to any of the preceding claims, wherein at least one groove (103,110,111) is formed on at least a first heat exchanging surface (11,12,102) by means of a machining operation.

13. Method of production of a heat exchanger for the conditioning of an electronic device according to any of the preceding claims from 1 a 11, wherein at least one groove (103,110,111) is formed on at least a first heat exchanging surface (11,12,102) by means of a molding operation.

14. Method of production of a heat exchanger for the conditioning of an electronic device according to any of the preceding claims from 1 a 11, wherein at least one groove (103,110,111) is formed on at least a first heat exchanging surface (11,12,102) by means of a casting operation.
